# EUROPÄISCHE PATENTSCHRIFT

(11) **EP 2 820 333 B1**
(45) Veröffentlichungstag und Bekanntmachung des Hinweises auf die Patenterteilung: **31.03.2021**
(21) Anmeldenummer: 13708348.1
(22) Anmeldetag: 27.02.2013
(51) Int. Cl.: F16H 55/08, C23C 14/24, F16H 25/16, F16H 57/02

(54) **VORRICHTUNG FÜR EIN VAKUUM UND ZUM ÜBERTRAGEN ODER ERMÖGLICHEN EINER BEWEGUNG**
DEVICE FOR A VACUUM AND FOR TRANSMITTING OR ENABLING A MOVEMENT
DISPOSITIF DESTINÉ À ÊTRE UTILISÉ DANS LE VIDE ET POUR TRANSMETTRE OU PERMETTRE UN MOUVEMENT

(30) Priorität: 29.02.2012 DE 102012004082
(43) Veröffentlichungstag der Anmeldung: 07.01.2015
(73) Patentinhaber: CreaTec Fischer & Co. GmbH, 74391 Erligheim (DE)
(72) Erfinder: BRAUN, Wolfgang, 74321 Bietigheim-Bissingen (DE)
(74) Vertreter: v. Bezold & Partner Patentanwälte - PartG mbB
(86) Internationale Anmeldenummer: PCT/EP2013/000580
(87) Internationale Veröffentlichungsnummer: WO 2013/127529

(56) Entgegenhaltungen:
- EP-A1- 1 970 474
- WO-A1-2010/006550
- US-A- 2 862 400
- US-A- 4 573 083
- US-A1- 2006 058 151

## Beschreibung

Die Erfindung betrifft eine Vakuumanlage mit einer Vorrichtung zur Bewegungsübertragung, Kraft-/Drehmomentübertragung und/oder Bewegungsermöglichung, vorzugsweise zur Ausbildung eines Gelenks, eines Getriebes, eines Lagers, einer Führung oder dergleichen. So eine Vakuumanlage ist aus der US4573083A bekannt.

Zum Stand der Technik ist zunächst auf US 2006/0058151 A1 zu verweisen, die einen Zahnradmechanismus mit Null-Grad-Betriebsdruckwinkel offenbart. Ferner ist die WO 2010/006550 A1 und die EP 1 970 474 A1 zu nennen.

Ultrahochvakuum ausbildende Bedampfungseinrichtungen zum Bedampfen eines Substrats mit einem Bedampfungsmaterial sind im Stand der Technik in unterschiedlichen Ausführungsformen bekannt. Eine beispielhafte Ausführungsform ist z.B. in DE 10 2007 012 370 A1 beschrieben. Herkömmliche Bedampfungseinrichtungen weisen üblicherweise eine Beschichtungs- oder Prozesskammer und zusätzliche Hilfskammern auf, wovon eine z.B. als Ladekammer ausgebildet sein kann. Die Kammern sind durch einen Transfertunnel verbunden, der durch ein Vakuumventil verschlossen werden kann. Die Kammern werden durch Vakuumpumpen zur Erzeugung eines Vakuums, insbesondere Hochvakuums evakuiert. Ein zu bedampfendes Werkstück wird nach Belüftung der Ladekammer über eine Ladeklappe in die Ladekammer eingeführt, woraufhin die Ladeklappe verschlossen und die Ladekammer abgepumpt wird. Nach dem Erreichen eines ausreichend niedrigen Drucks wird das Werkstück in der Ladekammer auf eine niedere Temperatur geheizt, um Oberflächenverunreinigungen wie z.B. Wasser oder Feuchtigkeit abzuheizen. Danach wird das Vakuumventil geöffnet und das Werkstück mit einer Transfereinrichtung in die Prozesskammer gebracht. Dort wird es an einer rotierbaren Heizeinrichtung, dem Substratmanipulator, angebracht, wo es für die Beschichtung beheizt und rotiert wird. Der Fluss des Verdampfungsguts aus dem Verdampferofen wird durch ein Verschlussteil vor dem Verdampferofen unterbrochen oder freigegeben. Nach der Bedampfung wird die Rotation gestoppt, die Probe abgekühlt und wieder in die Ladekammer transferiert, von wo aus sie nach dem Belüften der Ladekammer entnommen werden kann. Es ist ersichtlich, dass verschiedene Bewegungsvorgänge im Vakuum erforderlich sind, z.B. Drehbewegungen wie z.B. zur Werkstückdrehung, zumindest näherungsweise lineare Bewegungen wie z.B. für Verdampferzellenverschlüsse, zumindest näherungsweise lineare Bewegungen über relativ große Distanzen wie sie z.B. für den Werkstück-/Probentransfer notwendig sind, etc..

In der Vakuum-, insbesondere der Ultrahochvakuumtechnik können keine organischen Stoffe in Kontakt mit dem Vakuum verwendet werden, wenn man extrem niedrige Basisdrücke (z.B. 1,0 x 10⁻¹⁰ mbar) erreichen will. Dies trifft insbesondere dann zu, wenn gleichzeitig hohe Temperaturen (z.B. über 500 °C) auftreten, wie z.B. bei Bedampfungsprozessen erforderlich. Für bewegliche Teile stehen deshalb organische Schmiermittel nicht zur Verfügung. Die Materialauswahl ist auf hochschmelzende Metalle und Keramiken mit niedrigem Dampfdruck beschränkt. Für Linearbewegungen z.B. wird oft eine gleitende Bewegung eines harten, glatt polierten Teils, z.B. einer Edelstahl-Schubstange, in einer weicheren Buchse, z.B. aus Bronze, genutzt. Solche Kombinationen haben aber in der Regel eine eher geringe Lebensdauer, weil durch die fehlende Schmierung das weichere Material schnell abgetragen wird. Findet zusätzlich eine Belegung der Oberflächen durch verdampftes Material statt, wird das glatte Teil oft rau und es sinkt durch die dadurch erhöhte Reibung die Lebensdauer weiter. Rotationsbewegungen z.B. erfordern im Allgemeinen eine Achse mit endlichem Durchmesser. Somit tritt auch hier Reibung zwischen zwei Oberflächen auf. Normalerweise werden für diesen Anwendungsfall im Vakuum Kugellager verwendet, die aber nur auf den ersten Blick das Problem vermeiden, indem das Gleiten zweier Teile durch eine Rollbewegung ersetzt wird. Die Kugeln müssen aber durch Kugellagerkäfige in ihrer Position gehalten werden, die wiederum flächig an den Kugeln reiben und zu einer suboptimalen Standzeit führen. Selbst käfiglose Kugellager weisen dieses Problem auf, da hier die Kugeln mit der doppelten Abrollgeschwindigkeit seitlich gegeneinander reiben. So wird oft doch mit Schmiermitteln auf Feststoffbasis gearbeitet, welche jedoch als kleinste Partikel die Vakuumprozesse verunreinigen können und lediglich eine Verlängerung der Standzeit bewirken, da sie sich durch die Bewegung aus den Lagern arbeiten.

In Anbetracht obiger Ausführungen wird es Fachleuten anhand dieser Offenbarung ersichtlich, dass ein Bedarf an der Lösung oder Überwindung oben beschriebener Probleme oder Nachteile besteht. Diese Erfindung bezieht sich auf diesen Bedarf des Standes der Technik sowie auf andere Bedürfnisse, die Fachleuten anhand dieser Offenbarung ersichtlich werden.

Die sich aus vorstehend Genanntem ergebenden Aufgaben können mit den Merkmalen des unabhängigen Anspruchs gelöst werden. Die Erfindung ist jedoch nicht auf Ausführungsformen beschränkt, die sämtliche eingangs genannten Probleme oder Nachteile des Stands der Technik beseitigen. Vielmehr beansprucht die Erfindung auch allgemein Schutz für die nachstehend beschriebenen Ausführungsbeispiele.

Gemäß der Erfindung wird eine Vakuumanlage mit einer Vorrichtung bereitgestellt die die Merkmale des Anspruchs 1 aufweist.

Die Vorrichtung ist besonders für eine Vakuum-, insbesondere eine Ultrahochvakuumanlage, geeignet, vorzugsweise für eine Bedampfungseinrichtung zum Bedampfen eines Substrats mit einem Verdampfungsmaterial und/oder eine Einrichtung zur Molekularstrahlepitaxie.

Die Vorrichtung ist vorzugsweise für den Einsatz in einem Ultrahochvakuum (z.B. ≤ 1,0 x 10⁻⁸ mbar, ≤ 1,0 x 10⁻⁹ mbar oder sogar < 1,0 x 10⁻¹⁰ mbar) und/oder unter hohen Temperaturen (z.B. > 300°C, > 400°C, > 500°C oder > 600°C) geeignet. Die Vorrichtung kann zweckmäßig Mittel umfassen, um das vorstehend genannte Vakuum und/oder die vorstehend genannte Temperatur zu erzeugen.

Die Vorrichtung umfasst vorzugsweise zumindest einen Kerbe-Eingriffsteil-Mechanismus, der durch zumindest eine Kerbe und zumindest ein Eingriffsteil gebildet wird.

Insbesondere umfasst die Vorrichtung zusätzlich zu dem zumindest einen Kerbe-Eingriffsteil-Mechanismus zumindest zwei Kontaktflächen, wobei zumindest eine Kontaktfläche entlang der anderen Kontaktfläche, die dann zweckmäßig als Lauffläche ausgeführt ist, abrollen kann.

Die zumindest zwei Kontaktflächen dienen insbesondere der Lastaufnahme-/übertragung senkrecht zur Abrollrichtung.

Die Vorrichtung führt zweckmäßig zu zumindest einem von folgenden Vorteilen:
- eine gleichförmige, z.B. exakt lineare Bewegung, ist realisierbar
- Erschütterungen oder Vibrationen sind vermeidbar
- geringer Verschleiß durch eine kontinuierliche Abfolge von Berührungslinien mit 'Schneiden- oder Eingriffsteilwinkel null'
- eine Entkopplung der Bewegungsform von der Größe und Form der Führungsverzahnung. Dieser Punkt ist insbesondere für die fertigungstechnische Umsetzung von Bedeutung, weil nun wenige große Zähne gewählt werden können, die einfach und damit preiswert zu fertigen sind. Außerdem kann die Periode der Zahnung und damit die Höhe der Eingriffsteile oder Zähne nun relativ groß gewählt werden ohne die Laufruhe der Vorrichtung zu beeinträchtigen. Somit kann auch z.B. das Spiel eines Notlagers und damit die Fertigungstoleranzen aller damit zusammenhängenden Teile großzügiger dimensioniert werden. Die Vorrichtung ist folglich auch unanfällig gegen Ausfälle durch Verzug, der z.B. durch thermische Beanspruchung auftreten kann.

Das zumindest eine Eingriffsteil ist zum Eindringen in die zumindest eine Kerbe ausgebildet. Im Rahmen der Erfindung ist es z.B. möglich, dass zumindest eine Kerbe feststehend ist und zumindest ein Eingriffsteil beweglich ist und es durch die Bewegung des Eingriffsteils zum Kerben-Eingriffsteil-Eindringen kommt. Im Rahmen der Erfindung ist es aber alternativ oder ergänzend auch möglich, dass zumindest eine Kerbe beweglich ist und zumindest ein Eingriffsteil feststehend ist und es durch die Bewegung der Kerbe zum Kerben-Eingriffsteil-Eindringen kommt. Im Rahmen der Erfindung ist es außerdem möglich, dass sowohl die zumindest eine Kerbe als auch das zumindest eine Eingriffsteil beweglich sind. Das zumindest eine Eingriffsteil'ist folglich zweckmäßig zum aktiven und/oder passiven Eindringen in zumindest eine Kerbe ausgeführt.

Der Kerbe-Eingriffsteil-Mechanismus kann im Rahmen der Erfindung insbesondere als Verzahnungsmechanismus ausgeführt sein, z.B. als Zahnrad-Zahnstange-Konstruktion, Zahnrad-Zahnrad-Konstruktion, Zahnstange-Zahnrad-Zahnstange-Konstruktion oder sogar als Planetengetriebe. Bei dem Kerbe-Eingriffsteil-Mechanismus kann es sich z.B. um einen aus dem Stand der Technik bekannten, üblichen Verzahnungsmechanismus handeln. Der Kerbe-Eingriffsteil-Mechanismus kann aber auch z.B. gemäß der nicht vorveröffentlichten DE 10 2011 013 245 ausgeführt werden, so dass der Inhalt dieses Dokuments der vorliegenden Offenbarung in vollem Umfang zuzurechnen ist.

Der Kerbe-Eingriffsteil-Mechanismus dient vorzugsweise zur reproduzierbaren Positionierung und/oder zur Verhinderung einer Verkippung oder Verkantung eines beweglichen Teils zweckmäßig relativ zu einem feststehenden Teil der Vorrichtung. Der Kerbe-Eingriffsteil-Mechanismus dient alternativ oder ergänzend insbesondere zur seitlichen Führung eines beweglichen Teils zweckmäßig relativ zu einem feststehenden Teil der Vorrichtung. Die Führung und/oder die Verkippungs-/Verkantungsverhinderung wird vorzugsweise durch abrollende und/oder diskrete Wirkkontaktierungen zwischen einem feststehenden Teil und einem beweglichen Teil der Vorrichtung realisiert, zweckmäßig zwischen einem seitlichen Führungsabschnitt eines feststehenden Teils und zumindest einem Eingriffsteil eines beweglichen Teils. Die diskreten Wirkkontaktierungen können z.B. im Wesentlichen punkt- oder kantenförmig sein.

Es ist möglich, dass zumindest ein Kerbe-Eingriffsteil-Mechanismus seitlich z.B. unmittelbar neben den zwei Kontaktflächen ausgebildet ist.

Es ist auch möglich, dass die zwei Kontaktflächen zwischen zumindest zwei Kerbe-Eingriffsteil-Mechanismen ausgebildet sind, die z.B. quer zur Abrollrichtung voneinander beabstandet sind. Dadurch wird z.B. ermöglicht, dass die außenliegenden Kerbe-Eingriffsteil-Mechanismen durch innenliegende seitliche Führungen ein zweckmäßig maximales Führungsdrehmoment und/oder eine zweckmäßig maximale seitliche Führungskraft und damit eine minimale Abnutzung erfahren.

Vorzugsweise umfasst die zumindest eine Kerbe einen Kerbengrund und das zumindest eine Eingriffsteil umfasst vorzugsweise einen Stirnbereich.

Es ist möglich, dass eine Kontaktfläche zumindest nahezu bündig zu zumindest einem Kerbengrund ausgerichtet ist. Dabei kann die Kontaktfläche z.B. unmittelbar in den zumindest einen Kerbengrund übergehen oder zumindest geringfügig von dem zumindest einen Kerbengrund beabstandet sein. Vorzugsweise entspricht folglich der Radius der Kontaktfläche im Wesentlichen dem Fußkreis der Verzahnung oder Kerbe(n). Damit berührt die Kontaktfläche zweckmäßig in ihrer fiktiven Fortsetzung zumindest einen Kerbengrund.

Es ist ebenso möglich, dass die andere Kontaktfläche zumindest nahezu bündig zu zumindest einem Stirnbereich ausgerichtet ist. Dabei kann die Kontaktfläche z.B. unmittelbar in zumindest einen Stirnbereich übergehen oder zumindest geringfügig von zumindest einem Stirnbereich beabstandet sein. Damit berührt die Kontaktfläche zweckmäßig in ihrer gedachten Fortsetzung zumindest einen Stirnbereich.

Bei einer besonders bevorzugten Ausführungsform ist es möglich, dass eine Kontaktfläche zumindest nahezu bündig zu zumindest einem Kerbengrund ausgerichtet ist und während des Abrollens zeitweise zumindest nahezu bündig zu zumindest einem Stirnbereich ausgerichtet ist, und/oder die andere Kontaktfläche zumindest nahezu bündig zu zumindest einem Stirnbereich ausgerichtet ist und während des Abrollens zeitweise zumindest nahezu bündig zu zumindest einem Kerbengrund ausgerichtet ist.

Vorzugsweise sind zumindest ein Kerbengrund und zumindest ein Stirnbereich zur beweglichen und/oder kontaktierenden Wirkverbindung miteinander ausgebildet. Bei dieser Ausführungsform ist es möglich, dass zumindest ein Stirnbereich an zumindest einem Kerbengrund abstützbar ist oder umgekehrt. Bei dieser Ausführungsform ist vorzugsweise der zumindest eine Kerbengrund an einem beweglichen Teil ausgebildet und das zumindest eine Eingriffsteil ist vorzugsweise an einem feststehenden Teil ausgebildet.

Alternativ oder ergänzend ist es möglich, dass zumindest ein Kerbengrund und zumindest ein Stirnbereich so ausgebildet sind, dass sie zweckmäßig in Radialrichtung voneinander beabstandet sind, selbst wenn das entsprechende Eingriffsteil maximal in der entsprechenden Kerbe positioniert ist und es somit vorzugsweise selbst bei maximaler Eindringung zu keiner kontaktierenden Wirkverbindung kommt. Bei dieser Ausführungsform ist vorzugsweise der zumindest eine Kerbengrund an einem feststehenden Teil ausgebildet und das zumindest eine Eingriffsteil ist vorzugsweise an einem beweglichen Teil ausgebildet.

Es ist möglich, dass der zumindest eine Kerbe-Eingriffsteil-Mechanismus durch mehrere Kerben, die zweckmäßig jeweils einen Kerbengrund aufweisen, und mehrere Eingriffsteile, die zweckmäßig jeweils einen Stirnbereich aufweisen, gebildet wird.

Der Kerbe-Eingriffsteil-Mechanismus kann insbesondere so ausgebildet werden, dass eine kontaktierende Wirkverbindung eines Kerbengrund-Stirnbereich-Paars mittelbar oder unmittelbar in ein Kerbengrund-Stirnbereich-Paar, dessen Kerbengrund und Stirnbereich voneinander beabstandet bleiben, selbst wenn das entsprechende Eingriffsteil maximal in der entsprechenden Kerbe positioniert ist, übergeht oder umgekehrt. Dadurch wird es zweckmäßig ermöglicht, dass es in Abrollrichtung nur zwischen jedem zweiten Kerbengrund und jedem zweiten Stirnbereich zu einer kontaktierenden Wirkverbindung kommt und/oder der oder die dazwischenliegenden Kerbengründe und Stirnbereiche voneinander beabstandet bleiben, selbst wenn ein entsprechendes Eingriffsteil maximal in einer entsprechenden Kerbe positioniert ist.

Es ist möglich, dass eine Kontaktfläche zumindest einen Seitenabschnitt zur seitlichen Führung zumindest eines Eingriffsteils zweckmäßig entlang der Abrollrichtung umfasst. Die seitliche Führung erfolgt vorzugsweise durch eine abrollende und/oder vorübergehende Wirkkontaktierung zwischen dem Seitenabschnitt und zumindest einem Eingriffsteil. Die Wirckontaktierung kann vorzugsweise diskret, insbesondere im Wesentlichen punkt- oder kantenförmig, realisiert werden, z.B. in Abhängigkeit der weiter unten beschriebenen Schrägungskonfigurationen des Seitenabschnitts und des zu führenden Eingriffsteils.

Der Seitenabschnitt wird vorzugsweise durch eine oder mehrere Kerben freigelegt. Die Wirkkontaktierung wird vorzugsweise erzeugt, wenn ein zu führendes Eingriffsteil maximal in einer entsprechenden Kerbe positioniert ist.

Der Seitenabschnitt ist zweckmäßig an einem feststehenden Teil ausgebildet und das zumindest eine geführte Eingriffsteil ist zweckmäßig an einem beweglichen Teil ausgebildet.

Es ist möglich, dass der zumindest eine Seitenabschnitt ein- oder mehrseitig zweckmäßig zur Vertikalen abgeschrägt ist und/oder das zumindest eine Eingriffsteil ein- oder mehrseitig (z.B. konisch) zweckmäßig zur Radialrichtung abgeschrägt ist.

Insbesondere sind der Seitenabschnitt und zumindest ein Eingriffsteil so abgeschrägt, dass zur seitlichen Führung eine diskrete (z.B. im Wesentlichen punkt- oder kantenförmige) Wirkkontaktierung zwischen dem Seitenabschnitt und dem zumindest einen Eingriffsteil realisiert wird.

Vorzugsweise weisen der Seitenabschnitt und das zumindest eine Eingriffsteil unterschiedliche Schrägungswinkel auf, wobei der Schrägungswinkel des Seitenabschnitts vorzugsweise größer ist als der oder die Schrägungswinkel eines zu führenden Eingriffteils.

Es ist möglich, dass eine Kontaktfläche zumindest abschnittsweise eben ausgeführt ist (sich z.B. im Wesentlichen geradlinig erstreckt) und die andere Kontaktfläche im Querschnitt zumindest abschnittsweise gekrümmt, vorzugsweise kreis- oder kreisbogenförmig, ausgeführt ist. Die Kontaktfläche kann somit z.B. zylinder- oder kreiszylinderförmig ausgeführt sein. Es ist auch möglich, dass zwei Kontaktflächen im Querschnitt gekrümmt ausgeführt sind, z.B. für Konstruktionen der Zahnrad-Zahnrad-Art oder Konstruktionen, bei denen eine gekrümmte Kontaktfläche entlang einer anderen gekrümmten Kontaktfläche abrollen kann. Auch Hohlrad-Konstruktionen sind möglich, z.B. zur Ausbildung eines Planetengetriebes. Es sind sogar Ausführungsformen möglich, bei denen eine Kontakt/-Lauffläche schraubenlinienförmig oder kegelförmig ausgeführt ist.

Vorzugsweise sind an einem beweglichen Teil mehrere Kerben und Eingriffsteile ausgebildet und an einem feststehenden Teil mehrere Kerben und Eingriffsteile ausgebildet. Es ist möglich, dass die Kerben des beweglichen Teils unterschiedlich konfiguriert sind wie die Kerben des feststehenden Teils und/oder die Eingriffsteile des beweglichen Teils unterschiedlich konfiguriert sind wie die Eingriffsteile des feststehenden Teils.

Es ist möglich, dass zumindest ein Eingriffsteil zwei unterschiedlich konfigurierte Flankenabschnitte umfasst und/oder zumindest eine Kerbe zwei unterschiedlich konfigurierte Flankenabschnitte umfasst. In diesem Fall sind also die zumindest eine Kerbe und/oder das zumindest eine Eingriffsteil in Vorwärtsabrollrichtung und Rückwärtsabrollrichtung unterschiedlich ausgeführt.

Die Vorrichtung kann ein Funktionsteil umfassen, das vorzugsweise mittels des zumindest einen Kerbe-Eingriffsteil-Mechanismus und/oder den zumindest zwei Kontaktflächen so beweglich (z.B. verschiebbar, drehbar und/oder verschwenkbar) ist, dass es zweckmäßig zielorientiert von einer Ausgangsposition in eine Zielposition bringbar ist und umgekehrt.

Das Funktionsteil kann z.B. um mindestens 30 mm, 40 mm, 50 mm, 60 mm, 80 mm, 90 mm, 100 mm, 110 mm oder 120 mm beweglich, insbesondere verschiebbar sein.

Es ist möglich, dass die Vorrichtung ein Wirkmittel umfasst, das ausgebildet ist, um das Funktionsteil unmittelbar oder mittelbar anzutreiben. Das Wirkmittel ist vorzugsweise so ausgebildet, dass es das Funktionsteil von außen durch eine Kammerwand hindurch bewegen kann, zweckmäßig mittels fernwirkenden Kräften und/oder ohne dass es das Funktionsteil berührt und/oder ohne dass es dazu einer körperlichen Durchdringung der Kammerwand bedarf. Alternativ oder ergänzend ist das Wirkmittel vorzugsweise zur Erzeugung eines Andrucks zwischen den zumindest zwei Kontaktflächen ausgebildet, wodurch z.B. die zumindest zwei Kontaktflächen und/oder der zumindest eine Kerbe-Eingriffsteil-Mechanismus zusammengehalten werden. Der Andruck wird vorzugsweise von außen durch eine Kammerwand hindurch erzeugt, zweckmäßig mittels fernwirkenden Kräften und/oder ohne dass es dazu einer körperlichen Durchdringung der Kammerwand bedarf. Die fernwirkenden Kräfte umfassen insbesondere magnetische, elektromagnetische oder elektrostatische Kräfte.

Das Wirkmittel kann magnetisch sein und die Vorrichtung bzw. das der Vorrichtung zugeordnete Funktionsteil kann magnetisierbar sein oder umgekehrt. Es ist aber auch möglich, dass das Wirkmittel und die Vorrichtung bzw. das der Vorrichtung zugeordnete Funktionsteil magnetisch sind. Es können auch z.B. elektromagnetische Felder, elektrostatische Felder und/oder die Schwerkraft eingesetzt werden. Bei den Feldern kann es sich um (insbesondere elektromagnetische) Wanderfelder handeln. Das Wirkmittel arbeitet somit insbesondere mittels fernwirkenden Kräften.

Vorzugsweise ist das Wirkmittel motorisch antreibbar. Durch das zweckmäßig motorisch antreibbare Wirkmittel lassen sich insbesondere automatisierte Bewegungsabläufe z.B. des Funktionsteils realisieren. Bei dieser Ausführungsform umfasst die Vorrichtung somit vorzugsweise auch eine Motoreinrichtung zum Antreiben des Wirkmittels.

Es ist möglich, dass die Vorrichtung in einer durch eine Kammerwand begrenzten Kammer angeordnet ist, mit Ausnahme des Wirkmittels. Das Wirkmittel ist vorzugsweise außerhalb der Kammer angeordnet und/oder ist ausgeführt, um von außen mittels einer fernwirkenden Kraft durch die Kammerwand hindurch in die Kammer hinein zu wirken, z.B. um - zweckmäßig wie oben beschrieben - das Funktionsteil von einer Ausgangsposition in eine Zielposition zu bringen und/oder um den Andruck zwischen den zumindest zwei Kontaktflächen zu erzeugen. Das Wirkmittel kann unmittelbar oder mittelbar, z.B. über ein Kopplungsstück, auf das Funktionsteil wirken.

Die Kammer ist vorzugsweise eine Vakuum- oder gar Ultrahochvakuumkammer. Die Vorrichtung kann z.B. Mittel zur Erzeugung eines Vakuums oder gar Ultrahochvakuums in der Kammer und/oder Mittel zum Heizen der Kammer (z.B. über 400°C, 500° oder 600°C) umfassen. Die Mittel zum Heizen der Kammer können innerhalb oder außerhalb der Kammer angeordnet sein.

Die Vorrichtung umfasst außerdem vorzugsweise zumindest eine Nothalterung, die dafür sorgt, dass sich die zumindest zwei Kontaktflächen und/oder der zumindest eine Kerbe-Eingriffsteil-Mechanismus nicht übermäßig lockert, insbesondere wenn das Wirkmittel entfernt wird oder anderweitig ungenügend wirkt. Die Nothalterung kann so konfiguriert sein, dass sie ein bestimmtes Lockern der Vorrichtung, insbesondere der zumindest zwei Kontaktflächen und/oder des zumindest einen Kerbe-Eingriffsteil-Mechanismus, zulässt, aber ein übermäßiges Lockern verhindert, das z.B. zu einem Blockieren, Verkanten oder sogar Auseinanderfallen führen würde.

Bei einer bevorzugten Ausführungsform umfasst das Funktionsteil eine Verschlusseinrichtung zweckmäßig zum Öffnen und Schließen einer Öffnung oder eine Transfereinrichtung zweckmäßig zum Transferieren (z.B. zum Hin- und Herbewegen) von Proben oder Substraten oder allgemein von Werkstücken.

Zu erwähnen ist, dass vorzugsweise zumindest ein Eingriffsteil zu seinem Stirnbereich hin spitz zuläuft und somit vorzugsweise schneid- oder spitzförmig ausgebildet sein kann. Es ist aber auch möglich, dass zumindest ein Eingriffsteil z.B. bogenförmig oder im Wesentlichen rechteck- oder trapezförmig gestaltet ist, so dass der Stirnbereich im Rahmen der Erfindung z.B. auch durch eine etwa bogenförmige oder sogar ebene Fläche oder jedwede andere geeignete Konfiguration ausgebildet sein kann. Bevorzugt ist aber, dass zumindest ein Eingriffsteil als Schneide ausgeführt ist. Auch die Kerbe kann im Rahmen der Erfindung jedwede geeignete Konfiguration aufweisen.

Zu erwähnen ist außerdem, dass vorzugsweise die Kontaktierung zwischen den zumindest zwei Kontaktflächen durch den Kerbe-Eingriffsteil-Mechanismus nicht aufgehoben wird und somit z.B. zwischen der Ausgangsposition und der Zielposition stets eine Kontaktierung zwischen den zwei Kontaktflächen vorhanden ist.

Die Erfindung wurde vorstehend zum Teil unter Bezugnahme auf ein Eingriffsteil und eine Kerbe beschrieben. Es ist jedoch ersichtlich, dass die Erfindung insbesondere auch einen Kerbe-Eingriffsteil-Mechanismus umfasst, der durch mehrere Kerben und mehrere Eingriffsteile gebildet wird. Die vorstehend zum Teil unter Bezugnahme auf ein Eingriffsteil und eine Kerbe gemachte Beschreibung gilt somit entsprechend auch für die erfindungsgemäße Ausführungsform mit mehreren Kerben und mehreren Eingriffsteilen. Selbiges gilt für Ausführungsformen mit mehr als zwei Kontaktflächen, z.B. einem feststehenden Teil und mehr als einem beweglichen Teil.

Die Erfindung umfasst auch eine Vakuumanlage, insbesondere eine Einrichtung zur Molekularstrahlepitaxie und/oder zum Bedampfen eines Substrats mit einem Verdampfungsmaterial, die eine wie hierin beschriebene Vorrichtung umfasst. Die Vakuumanlage kann z.B. als Ultrahochvakuumanlage ausgeführt sein, die zweckmäßig geeignet ist, ein Ultrahochvakuum von vorzugsweise ≤ 1,0 x 10⁻⁸ mbar, ≤ 1,0 x 10⁻⁹ mbar oder sogar ≤ 1,0 x 10⁻¹⁰ mbar zu erzeugen. Alternativ oder ergänzend kann die Vakuumanlage geeignet sein, eine Temperatur von z.B. über 300°C, über 400°C, über 500°C oder sogar über 600°C zu erzeugen.

Die Vakuumanlage umfasst vorzugsweise eine Kammer und zweckmäßig Mittel zur Erzeugung des vorher erwähnten Vakuums in der Kammer. Außerdem kann eine Heizeinrichtung zum Heizen der Kammer auf die vorstehend erwähnten Temperaturen vorgesehen sein. Die Kammer wird zweckmäßig durch eine Kammerwand begrenzt.

Die Vakuumanlage kann eine durch eine Kammerwand begrenzte Kammer und Mittel zur Erzeugung eines Vakuums in der Kammer und/oder eine Heizeinrichtung zum Heizen der Kammer aufweisen.

Die Vakuumanlage kann eine Einrichtung zur Molekularstrahlepitaxie und/oder eine Einrichtung zum Bedampfen eines Substrats mit einem Verdampfungsmaterial umfassen.

Die oben beschriebenen Merkmale und bevorzugten Ausführungsbeispiele der Erfindung sind beliebig miteinander kombinierbar. Andere vorteilhafte Weiterbildungen der Erfindung sind in den Unteransprüchen offenbart oder ergeben sich aus der nachstehenden Beschreibung bevorzugter Ausführungsbeispiele der Erfindung in Verbindung mit den beigefügten Figuren.
- Figur 1: zeigt eine skizzenhafte Seitenansicht einer Vorrichtung gemäß einer Ausführungsform der Erfindung,
- Figur 2: zeigt eine vergrößerte skizzenhafte Darstellung eines Teils der Vorrichtung aus Figur 1,
- Figur 3: zeigt eine vergrößerte skizzenhafte Darstellung eines Teils der Vorrichtung aus Figur 1,
- Figur 4: zeigt eine skizzenhafte Seitenansicht einer Vorrichtung gemäß einer anderen Ausführungsform der Erfindung,
- Figur 5: zeigt eine skizzenhafte Seitenansicht einer Vorrichtung gemäß einer wiederum anderen Ausführungsform der Erfindung,
- Figur 6: zeigt eine Seitenansicht einer Vorrichtung gemäß einer wiederum anderen Ausführungsform der Erfindung,
- Figur 7: zeigt eine perspektivische Ansicht der Vorrichtung aus Figur 6,
- Figur 8: zeigt eine andere perspektivische Ansicht der Vorrichtung aus Figur 6,
- Figur 9: zeigt eine vergrößerte perspektivische Darstellung eines Teils der Vorrichtung aus Figur 6,
- Figur 10: zeigt eine Vorderansicht der Vorrichtung aus Figur 6,
- Figur 11: zeigt eine Schnittansicht der Vorrichtung aus Figur 6,
- Figur 12: zeigt eine vergrößerte Darstellung des in Figur 11 gekennzeichneten Abschnitts, und
- Figur 13: zeigt eine perspektivische Schnittansicht einer Vorrichtung gemäß einer Ausführungsform der Erfindung.

Die nachstehend beschriebenen Ausführungsformen stimmen teilweise überein, wobei ähnliche oder identische Teile mit dem gleichen Bezugszeichen versehen sind, und zu deren Erläuterung auch auf die jeweilige Beschreibung anderer Ausführungsformen verwiesen wird, um Wiederholungen zu vermeiden.

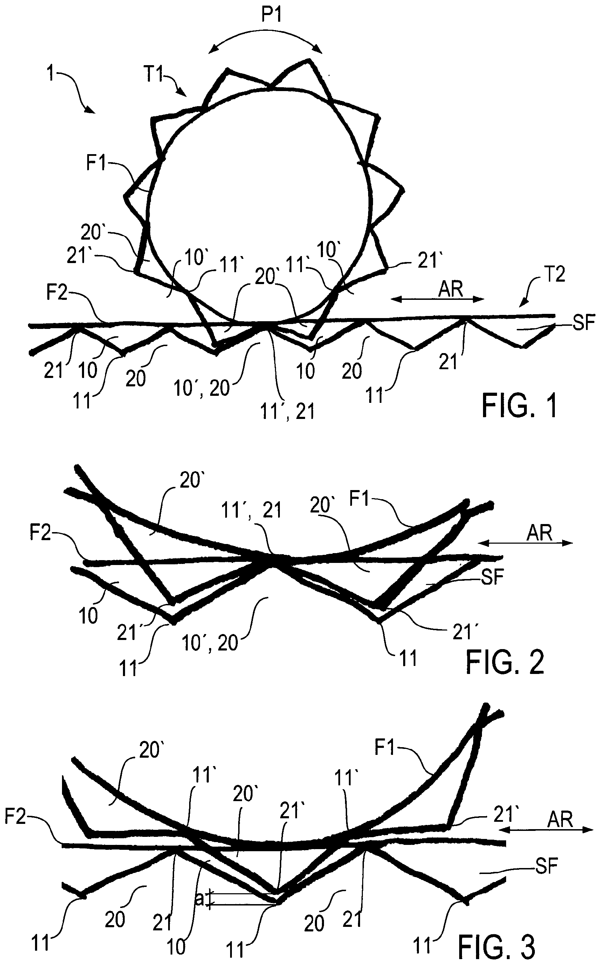

Figur 1 zeigt eine skizzenhafte Seitenansicht einer Vorrichtung 1 zur Bewegungsübertragung, Drehmomentübertragung, Kraftübertragung und/oder Bewegungsermöglichung gemäß einer Ausführungsform der Erfindung. Die Vorrichtung 1 ist insbesondere zur Verwendung in einem Vakuum, insbesondere einem Ultrahochvakuum geeignet.

Die Vorrichtung 1 umfasst ein erstes Teil T1, das eine Vielzahl von Kerben 10', die jeweils einen Kerbengrund 11' aufweisen, und eine Vielzahl von Eingriffsteilen 20', die jeweils einen Stirnbereich 21' aufweisen, umfasst.

Die Vorrichtung 1 umfasst ferner ein zweites Teil T2, das eine Vielzahl von Kerben 10, die jeweils einen Kerbengrund 11 aufweisen, und eine Vielzahl von Eingriffsteilen 20, die jeweils einen Stirnbereich 21 aufweisen, umfasst.

Die Kerben 10' und Eingriffsteile 20' des ersten Teils T1 bilden mit den Kerben 10 und Eingriffsteilen 20 des zweiten Teils T2 einen Kerbe-Eingriffsteil-Mechanismus.

Zusätzlich zu dem Kerbe-Eingriffsteil-Mechanismus umfasst die Vorrichtung 1 eine Kontaktfläche F1, die an dem ersten Teil T1 ausgeführt ist, und eine Kontaktfläche F2, die an dem zweiten Teil T2 ausgeführt ist.

Die zwei Kontaktflächen F1, F2 sind so ausgebildet, dass die Kontaktfläche F1 entlang der Kontaktfläche F2 abrollen kann. Bezugszeichen AR kennzeichnet dabei die Abrollrichtung. Die erste Kontaktfläche F1 ist gemäß Pfeil P1 hin- und herbeweglich (drehbar) und z.B. kreisförmig ausgeführt. Die zweite Kontaktfläche F2 ist feststehend und eben oder planar ausgeführt. In einer anderen Ausführungsform kann auch die zweite Kontaktfläche F2 gekrümmt ausgeführt werden.

Die Kontaktfläche F1 ist bündig zu den Kerbengründen 11' des ersten Teils T1 ausgebildet. Die Kontaktfläche F2 ist bündig zu den Stirnbereichen 21 des zweiten Teils T2 ausgebildet. Die Kontaktfläche F1 ist während eines Abrollvorgangs zeitweise zumindest nahezu bündig zu den Stirnbereichen 21 des zweiten Teils T2 ausgerichtet und die Kontaktfläche F2 ist während eines Abrollvorgangs zeitweise zumindest nahezu bündig zu den Kerbengründen 11' des ersten Teils T1 ausgerichtet.

Die Kerbengründe 11' des ersten Teils T1 und die Stirnbereiche 21 des zweiten Teils T2 sind zur zweckmäßig wechselnden kontaktierenden Wirkverbindung miteinander ausgebildet.

An der Kontaktfläche F2 ist ferner ein Seitenabschnitt SF zur seitlichen Führung der Eingriffsteile 20' des ersten Teils T1 vorgesehen, wobei der Seitenabschnitt SF durch die Kerben 10 des zweiten Teils T2 freigelegt wird.

Figur 2 zeigt eine vergrößerte skizzenhafte Darstellung eines Teils der Vorrichtung 1 aus Figur 1, während ein Kerbengrund 11' des ersten Teils T1 und ein Stirnbereich 21 des zweiten Teils T2 eine kontaktierende Wirkverbindung ausbilden.

Figur 3 zeigt eine vergrößerte skizzenhafte Darstellung eines Teils der Vorrichtung 1 aus Figur 1, während ein Stirnbereich 21' des ersten Teils T1 und ein Kerbengrund 11 des zweiten Teils T2 voneinander um einen Abstand a voneinander beabstandet sind und somit keine kontaktierende Wirkverbindung ausbilden, obwohl das entsprechende Eingriffsteil 20' des ersten Teils T1 maximal in einer entsprechenden Kerbe 10 des zweiten Teils T2 positioniert ist.

Die in den Figuren 1 bis 3 gezeigte Vorrichtung 1 ist folglich so konfiguriert, dass nur die Kerbengründe 11' des ersten Teils T1 mit den Stirnbereichen 21 des zweiten Teils T2 eine kontaktierende Wirkverbindung bilden können, während die Stirnbereiche 21' des ersten Teils T1 und die Kerbengründe 11 des zweiten Teils T2 keine kontaktierende Wirkverbindung ausbilden und somit voneinander beabstandet bleiben, selbst wenn ein entsprechendes Eingriffsteil 20' des ersten Teils T1 maximal in eine entsprechende Kerbe 10 des zweiten Teils T2 eindringt. Der Kerbe-Eingriffsteil-Mechanismus ist somit so ausgebildet, dass eine kontaktierende Wirkverbindung eines Kerbengrund-Stirnbereichs-Paars 11', 21 mittelbar oder unmittelbar in ein selbst bei maximaler Eindringung nicht kontaktierendes Kerbengrund-Stirnbereich-Paar 11, 21' übergeht oder umgekehrt, während zwischen den Kontaktflächen F1 und F2 stets eine Kontaktierung stattfindet.

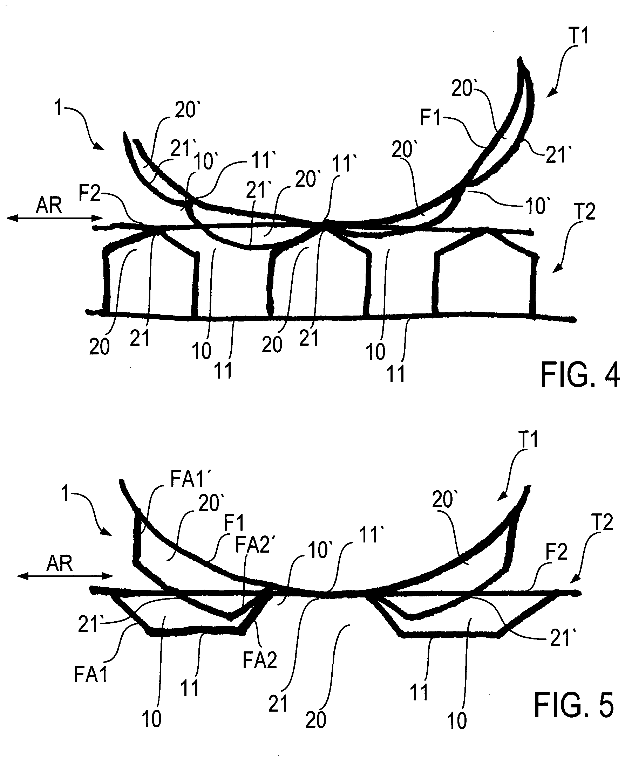

Figur 4 zeigt eine skizzenhafte Seitenansicht einer Vorrichtung 1 einer anderen Ausführungsform der Erfindung. Da es ausreicht, dass nur die Kerbengründe 11' des ersten Teils T1 mit den Stirnbereichen 21 des zweiten Teils T2 eine kontaktierende Wirkverbindung ausbilden können, kann die Form, Anordnung und/oder Konfiguration der Kerben 10 und des Eingriffsteils 20' zwischen den aktiven Kerbengrund 11' - Stirnbereich 21 - Eingriffen frei gewählt werden. Diese Freiheit kann z.B. für die fertigungstechnische und damit preisliche Optimierung der Vorrichtung 1 interessant sein, da die Form, Anordnung und/oder Konfiguration der frei wählbaren Kerben und Eingriffsteile optimal dem günstigsten Fertigungsverfahren angepasst werden kann. So können z.B. die Eingriffsteile 20' des ersten Teils T1 eine andere Kontur oder Gestalt aufweisen wie die Eingriffsteile 20 des zweiten Teils T2. Ferner können die Kerben 10' des ersten Teils T1 eine andere Kontur oder Gestalt aufweisen wie die Kerben 10 des zweiten Teils T2.

Figur 5 zeigt eine skizzenhafte Seitenansicht einer Vorrichtung 1 gemäß einer wiederum anderen Ausführungsform der Erfindung. Das erste Teil T1 umfasst Eingriffsteile 20' und Kerben 10', die jeweils zwei unterschiedlich konfigurierte Flankenabschnitte FA1' und FA2' umfassen. Das zweite Teil T2 umfasst Eingriffsteile 20 und Kerben 10, die ebenso jeweils zwei unterschiedlich konfigurierte Flankenabschnitte FA1 und FA2 umfassen.

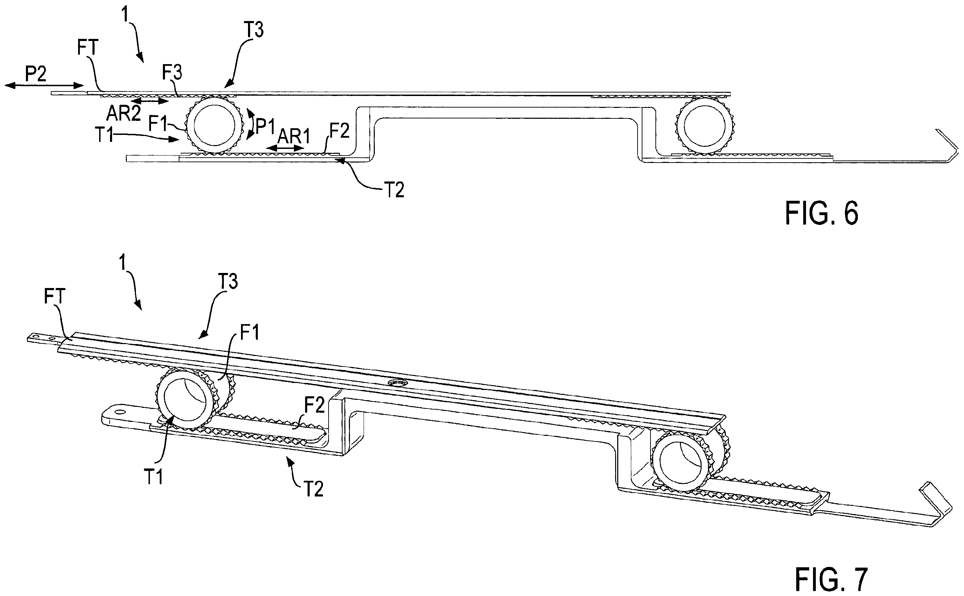

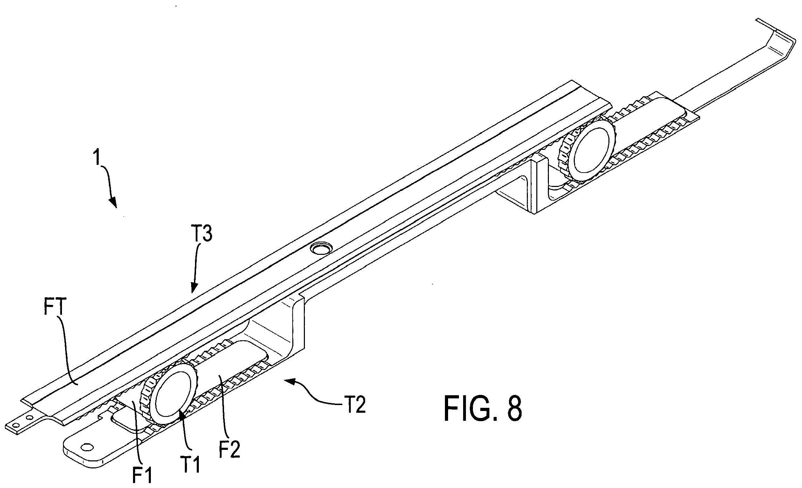

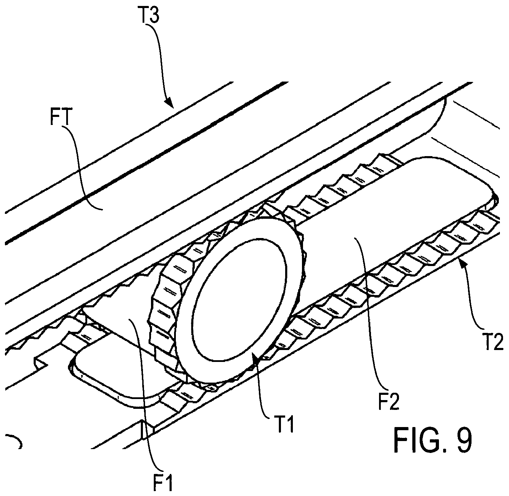

Figur 6 zeigt eine Seitenansicht einer Vorrichtung 1 gemäß einer wiederum anderen Ausführungsform der Erfindung, während die Figuren 7 und 8 eine perspektivische Ansicht der Vorrichtung 1 aus Figur 6 zeigen. Figur 9 zeigt eine vergrößerte perspektivische Darstellung eines Teils der Vorrichtung 1 aus den Figuren 6 bis 8. Der Klarheit wegen sind in den Figuren 6 bis 12 die Bezugszeichen für die Kerben und Eingriffsteile weggelassen.

Unter Bezugnahme auf die Figuren 6 bis 8 wird nur der linke Teil der Vorrichtung 1 beschrieben. Der rechte Teil der Vorrichtung 1 ist im Wesentlichen identisch ausgeführt, so dass auf die Beschreibung zum linken Teil verwiesen werden kann, um Wiederholungen zu vermeiden.

Wie in den Figuren 6 bis 9 gesehen werden kann, umfasst der linke Teil der Vorrichtung 1 eine erste Kontaktfläche F1, die an einem ersten Teil T1 ausgebildet ist, eine zweite Kontaktfläche F2, die an einem zweiten Teil T2 ausgebildet ist, und eine dritte Kontaktfläche F3, die an einem dritten Teil T3 ausgebildet ist. Das erste Teil T1 und somit die erste Kontaktfläche F1 ist gemäß Pfeil P1 drehbar, während das zweite Teil T2 feststehend ist und das dritte Teil T3 gemäß Pfeil P2 transversal oder zumindest quasilinear hin- und herverschiebbar ist.

Zwischen der ersten Kontaktfläche F1 und der zweiten Kontaktfläche F2 kann ein Abrollvorgang entlang einer Abrollrichtung AR1 stattfinden und zwischen der ersten Kontaktfläche F1 und der dritten Kontaktfläche F3 kann ein Abrollvorgang entlang einer Abrollrichtung AR2 stattfinden.

Das zweite Teil T2 umfasst eine Tasche, in die ein Edelstahlteil eingesetzt ist, das die zweite Kontaktfläche F2 ausbildet. Die zweite Kontaktfläche F2 kann aber auch unmittelbar an dem zweiten Teil T2 ausgeführt sein, z.B. integral oder einstückig.

Das erste Teil T1 umfasst an zwei seiner Seiten mehrere Eingriffsteile 20' und Kerben 10' und das zweite Teil T1 umfasst an zwei seiner Seiten mehrere Eingriffsteile 20 und Kerben 10. Die Eingriffsteile 20' und die Kerben 10' des ersten Teils T1 bilden mit den Eingriffsteilen 20 und Kerben 10 des zweiten Teils T2 zwei Kerbe-Eingriffsteil-Mechanismen, zwischen denen die Kontaktflächen F1 und F2 positioniert sind. Die Kerbe-Eingriffsteil-Mechanismen sind quer zur Abrollrichtung AR1 voneinander beabstandet.

Das dritte Teil T3 umfasst ebenfalls an zwei seiner Seiten mehrere Kerben und Eingriffsteile, die im Wesentlichen identisch zu den Kerben 10 und Eingriffsteilen 20 des zweiten Teils T2 ausgeführt sein können. Die Eingriffsteile 20' und die Kerben 10' des ersten Teils T1 bilden mit den Eingriffsteilen und Kerben des dritten Teils T3 zwei Kerbe-Eingriffsteil-Mechanismen, zwischen denen die Kontaktflächen F1 und F3 positioniert sind. Die Kerbe-Eingriffsteil-Mechanismen sind quer zur Abrollrichtung AR2 voneinander beabstandet.

Das dritte Teil T3 ist ein Funktionsteil FT oder ist ausgebildet, um ein Funktionsteil FT zweckmäßig mittelbar oder unmittelbar zu halten und zu bewegen. Das Funktionsteil FT ist z.B. mittels fernwirkenden Kräften gemäß Pfeil P2 antreibbar und kann z.B. als Verschlusseinrichtung zum Schließen und Öffnen einer Öffnung ausgebildet sein oder als Proben- oder Substrattransfereinrichtung zum Transportieren von Proben- oder Substraten.

Das Funktionsteil FT ist mittels der Kontaktflächen F1, F2 und F3 und mittels der vier Kerbe-Eingriffsteil-Mechanismen so beweglich, dass es von einer Ausgangsposition zielorientiert in eine Zielposition bewegt werden kann, wobei die Bewegung zweckmäßig zumindest quasi-linear oder transversal ist.

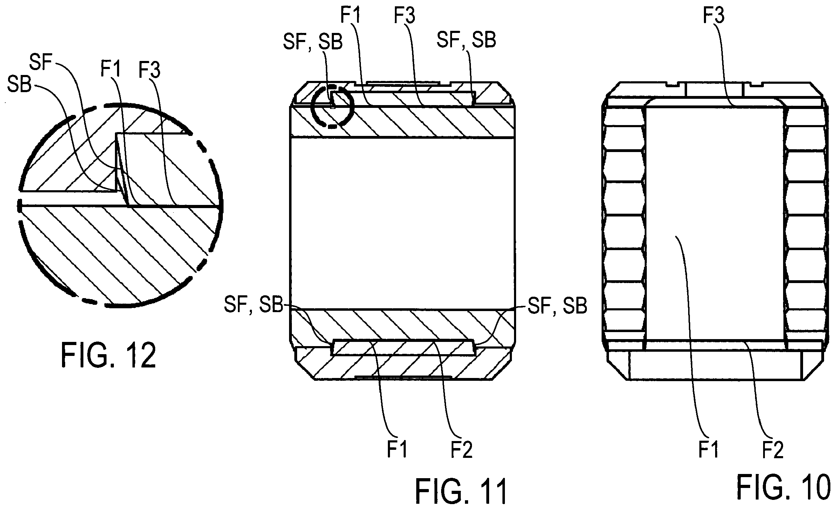

Figur 10 zeigt eine Vorderansicht der Vorrichtung 1 aus den Figuren 6 bis 9. Figur 11 zeigt eine Schnittansicht durch das erste Teil T1, das zweite Teil T2 und das dritte Teil T3 aus den Figuren 6 bis 10, während Figur 12 eine vergrößerte Darstellung des in Figur 11 gekennzeichneten Abschnitts zeigt.

Der Vorderansicht der Figur 10 kann nochmals entnommen werden, dass das Kontaktflächen-Paar F1 und F2 zwischen zwei Kerbe-Eingriffsteil-Mechanismen ausgebildet ist und das Kontaktflächen Paar F1 und F3 zwischen zwei Kerbe-Eingriffsteil-Mechanismen ausgebildet.

Die Schnittansicht der Figur 11 zeigt Seitenabschnitte SF, die zur seitlichen Führung der beweglichen Teile T1 und T3 dienen. Insbesondere weist die erste Kontaktfläche F1 an ihren zwei Längsseiten einen um ungefähr 10° zur Vertikalen abgeschrägten Seitenabschnitt SF auf, der sich in Figur 11 nach oben hin verjüngt. Auch die dritte Kontaktfläche F3 weist an ihren zwei Längsseiten einen um ungefähr 10° zur Vertikalen abgeschrägten Seitenabschnitt SF auf, der sich in Figur 11 nach unten hin verjüngt.

Wie in den Figuren 11 und 12 gesehen werden kann, umfassen die Eingriffsteile 20' des ersten Teils T1 ein- oder mehrseitig (zweckmäßig konisch) um z.B. 20° zur Radialrichtung abgeschrägte Seitenbereiche SB.

Die seitliche Führung erfolgt durch eine vorübergehende, abrollende Wirkkontaktierung zwischen den abgeschrägten Eingriffsteilen 20' des ersten Teils T1 und der abgeschrägten Seitenabschnitte SF des zweiten Teils T2 und des dritten Teils T3. Die Wirkkontaktierung erfolgt entsprechend der Schrägungskonfiguration vorzugsweise auf diskrete Art und Weise, das heißt im Wesentlichen punkt- oder kantenförmig. Die Wirkkontaktierung entsteht zweckmäßig dann, wenn die Eingriffsteile 20' des ersten Teils T1 maximal in den Kerben 10 des zweiten Teils T2 und den Kerben des dritten Teils T3 positioniert sind. An den Längsrändern der drei Kontaktflächen F1, F2 und F3 wird somit eine seitliche linienförmige Führung gebildet, bei einem Öffnungswinkel von z.B. 10°, der zwischen den 20°-Führungsschrägen an dem ersten Teil T1 abzüglich der 10°-Führungsschrägen an dem zweiten Teil T2 und dem dritten Teil T3 gebildet wird.

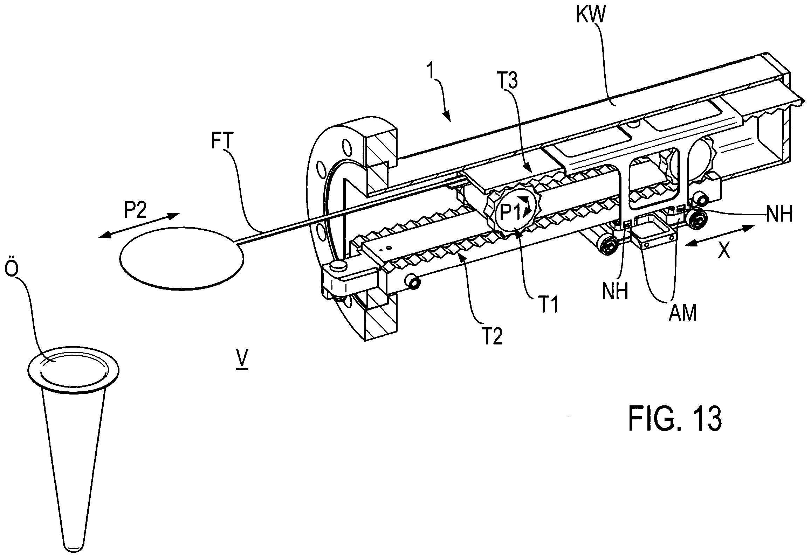

Figur 13 zeigt eine perspektivische Schnittansicht einer Vorrichtung 1, die zweckmäßig gemäß den Figuren 6 bis 12 ausgeführt ist. Figur 13 zeigt insbesondere einen sogenannten Linearshutter in einer Vakuumanlage, insbesondere einer Einrichtung zur Molekularstrahlepitaxie oder zum Bedampfen eines Substrats mit einem Bedampfungsmaterial.

Die Vakuumanlage umfasst eine Kammer, die durch eine Kammerwand KW begrenzt wird, wobei in Figur 13 nur der Teil der Kammerwand KW gezeigt ist, der unmittelbar die Vorrichtung 1 umgibt. Die Vakuumanlage umfasst ferner nicht gezeigte Mittel zur Erzeugung eines Vakuums V in der Kammer, die somit eine Vakuumkammer darstellt, und ebenso nicht gezeigte Mittel zum Heizen der Kammer. Die Mittel zum Heizen der Kammer können innerhalb oder außerhalb der Kammer positioniert sein. Das Bezugszeichen Ö kennzeichnet eine Verdampferofenöffnung, die ebenfalls in der Kammer positioniert ist und somit einem Vakuum aussetzbar ist. Das Funktionsteil FT ist als Verschlussteil ausgeführt, um die Verdampferofenöffnung zu öffnen und zu schließen.

Die Vorrichtung 1 umfasst außerdem Wirkmittel AM zum Bewegen des Funktionsteils FT. Das Wirkmittel AM kann mittels einer Motoreinrichtung (nicht gezeigt) gemäß Pfeil X motorisch hin- und herbewegt werden. Das Funktionsteil FT wird daraufhin gemäß Pfeil P2 hin- und herbewegt, was wiederum dazu führt, dass das erste Teil T1 gemäß Pfeil P1 auf dem feststehenden Teil T2 hin- und hergedreht wird. Somit kann das Funktionsteil FT von einer Ausgangsposition (Öffnung Ö geöffnet) in eine Zielposition (Öffnung geschlossen) verschoben werden oder umgekehrt.

Das Wirkmittel AM bewegt mittelbar oder unmittelbar das Funktionsteil FT von außen durch die Kammerwand KW hindurch, ohne dass es das Funktionsteil FT dazu berührt und ohne dass es dazu einer körperlichen Durchdringung der Kammerwand KW bedarf. Das wird dadurch realisiert, dass das Wirkmittel AM mittels fernwirkenden, z.B. magnetischen, elektromagnetischen oder elektrostatischen, Kräften arbeitet.

Das Wirkmittel AM ist außerdem so ausgebildet, dass es einen Andruck zwischen den Kontaktflächen F1 und F2 und F1 und F3 und/oder einen Andruck zwischen zumindest einem Kerbengrund und zumindest einem Stirnbereich, die eine kontaktierende Wirkverbindung miteinander ausbilden, erzeugt, wodurch die Vorrichtung 1 zusammengehalten werden kann. Der Andruck wird von außen durch die Kammerwand KW hindurch erzeugt, ohne dass es dazu einer körperlichen Durchdringung der Kammerwand KW bedarf. Das wird wiederum dadurch realisiert, dass das Wirkmittel AM mittels fernwirkenden, z.B. magnetischen, elektromagnetischen oder elektrostatischen, Kräften arbeitet.

Die Vorrichtung 1 umfasst ferner Nothalterungen NH (z.B. Anschläge, Anlagen, Klammern, Lager, etc.), die die Vorrichtung 1 zusammenhalten. Die Nothalterungen NH verhindern, dass sich bei abgenommenem oder anderweitig nicht oder nur gering wirkendem Wirkmittel AM die Kontaktflächen F1, F2 und F3 und die Kerbe-Eingriffsteil-Mechanismen übermäßig lockern, was z.B. zu einem Blockieren, Verkanten oder sogar Auseinanderfallen führen könnte.

## Patentansprüche

1. Vakuumanlage mit einer Vorrichtung zur Bewegungsübertragung, Drehmomentübertragung, Kraftübertragung und/oder Bewegungsermöglichung, insbesondere zur Ausbildung eines Getriebe- und/oder Führungsmechanismus, mit:
- zumindest einem Kerbe-Eingriffsteil-Mechanismus, der durch zumindest eine Kerbe (10, 10') und zumindest ein Eingriffsteil (20, 20') gebildet wird,
wobei
- zusätzlich zumindest zwei Kontaktflächen (F1, F2) ausgebildet sind und zumindest eine Kontaktfläche (F1) entlang der anderen Kontaktfläche (F2) abrollen kann, **dadurch gekennzeichnet, dass**
- an einer Kontaktfläche (F2) zumindest ein Seitenabschnitt (SF) zur seitlichen Führung zumindest eines Eingriffsteils (20') vorgesehen ist und die seitliche Führung durch zumindest eine vorübergehende, diskrete Wirkkontaktierung zwischen dem Seitenabschnitt (SF) und dem zumindest einen Eingriffsteil (20') erfolgt, und wobei
- ein Funktionsteil (FT), das mittels der zumindest zwei Kontaktflächen (F1, F2) und dem zumindest einen Kerbe-Eingriffsteil-Mechanismus so beweglich ist, dass es von einer Ausgangsposition in eine Zielposition bringbar ist und umgekehrt, wobei das Funktionsteil (FT) eine Verschlusseinrichtung zum Öffnen und Schließen einer Öffnung (Ö) umfasst oder eine Werkstücktransfereinrichtung zum Transferieren von Werkstücken, und
- ein motorisch antreibbares Wirkmittel (AM), das ausgebildet ist, um einen Andruck zwischen den zumindest zwei Kontaktflächen (F1, F2) zu erzeugen und um das Funktionsteil (FT) zu bewegen, und wobei
- der Andruck von außen durch eine Kammerwand hindurch mittels einer fernwirkenden Kraft erzeugt wird, und das Funktionsteil (FT) von außen durch die Kammerwand hindurch mittels einer fernwirkenden Kraft bewegt wird, und wobei
- die Vorrichtung innerhalb einer Kammer angeordnet ist, mit Ausnahme des Wirkmittels (AM), das außerhalb der Kammer angeordnet ist, um von außen mittels einer fernwirkenden Kraft durch die Kammerwand (KW) hindurch in die Kammer hinein zu wirken.

2. Vakuumanlage mit der Vorrichtung nach Anspruch 1, **dadurch gekennzeichnet, dass**
- zumindest ein Kerbe-Eingriffsteil-Mechanismus seitlich zu den zwei Kontaktflächen (F1, F2) ausgebildet ist, oder
- zumindest zwei Kerbe-Eingriffsteil-Mechanismen ausgebildet sind, zwischen denen die zwei Kontaktflächen (F1, F2) angeordnet sind.

3. Vakuumanlage mit der Vorrichtung nach einem der vorhergehenden Ansprüche, **dadurch gekennzeichnet, dass** die zumindest eine Kerbe (10, 10') einen Kerbengrund (11, 11') und das zumindest eine Eingriffsteil (20, 20') einen Stirnbereich (21, 21') aufweist.

4. Vakuumanlage mit der Vorrichtung nach Anspruch 3, **dadurch gekennzeichnet, dass** eine Kontaktfläche (F1) zumindest nahezu bündig zu zumindest einem Kerbengrund (11') ausgebildet ist und die andere Kontaktfläche (F2) zumindest nahezu bündig zu zumindest einem Stirnbereich (21) ausgebildet ist.

5. Vakuumanlage mit der Vorrichtung nach Anspruch 3 oder 4, **dadurch gekennzeichnet, dass** eine Kontaktfläche (F1) während eines Abrollvorgangs eine zumindest nahezu bündige Ausrichtung zu zumindest einem Stirnbereich (21) einnimmt, und die andere Kontaktfläche (F2) während des Abrollvorgangs eine zumindest nahezu bündige Ausrichtung zu zumindest einem Kerbengrund (11') einnimmt.

6. Vakuumanlage mit der Vorrichtung nach einem der Ansprüche 3 bis 5, **dadurch gekennzeichnet, dass** zumindest ein Kerbengrund (11') und zumindest ein Stirnbereich (21) zur kontaktierenden Wirkverbindung miteinander ausgebildet sind, wobei der zumindest eine Kerbengrund (11') an einem beweglichen Teil (T1) ausgebildet ist und der zumindest eine Stirnbereich (21) an einem feststehenden Teil (T2) ausgebildet ist.

7. Vakuumanlage mit der Vorrichtung nach einem der Ansprüche 3 bis 6, **dadurch gekennzeichnet, dass** zumindest ein Kerbengrund (11) und zumindest ein Stirnbereich (21') so ausgebildet sind, dass sie voneinander beabstandet bleiben, selbst wenn das entsprechende Eingriffsteil (20') maximal in einer entsprechenden Kerbe (10) positioniert ist, wobei der Kerbengrund (11) an einem feststehenden Teil (T2) ausgebildet ist und der Stirnbereich (21') an einem beweglichen Teil (T1) ausgebildet ist.

8. Vakuumanlage mit der Vorrichtung nach einem der vorhergehenden Ansprüche, **dadurch gekennzeichnet, dass** der Kerbe-Eingriffsteil-Mechanismus so ausgebildet ist, dass einer kontaktierenden Wirkverbindung eines Kerbengrund-Stirnbereich-Paars (11', 21) ein Kerbengrund-Stirnbereich-Paar (11, 21') folgt, dessen Kerbengrund (11) und Stirnbereich (21') voneinander beabstandet bleiben, selbst wenn das entsprechende Eingriffsteil (20') maximal in der entsprechenden Kerbe (10) positioniert ist, oder umgekehrt.

9. Vakuumanlage mit der Vorrichtung nach einem der vorhergehenden Ansprüche, **dadurch gekennzeichnet, dass** an einer Kontaktfläche (F2) zumindest ein Seitenabschnitt (SF) zur seitlichen Führung zumindest eines Eingriffsteils (20') vorgesehen ist, der durch zumindest eine Kerbe (10) freigelegt wird.

10. Vakuumanlage mit der Vorrichtung nach einem der vorhergehenden Ansprüche, **dadurch gekennzeichnet, dass** der zumindest eine Seitenabschnitt (SF) und das zumindest eine Eingriffsteil (20') zur seitlichen Führung abgeschrägt sind.

11. Vakuumanlage mit der Vorrichtung nach einem der vorhergehenden Ansprüche, **dadurch gekennzeichnet, dass** der Seitenabschnitt (SF) mit einem anderen Schrägungswinkel abgeschrägt ist wie das zumindest eine Eingriffsteil (20').

12. Vakuumanlage mit der Vorrichtung nach einem der vorhergehenden Ansprüche, **dadurch gekennzeichnet,**
- **dass** eine Kontaktfläche (F1) zumindest abschnittsweise gekrümmt, nämlich kreis- oder kreisbogenförmig, ausgeführt ist, und die andere Kontaktfläche (F2) zumindest abschnittsweise eben ausgeführt ist, oder
- **dass** zwei Kontaktflächen (F1, F2) gekrümmt, nämlich kreis- oder kreisbogenförmig, ausgeführt sind.

13. Vakuumanlage mit einer Vorrichtung nach einem der vorhergehenden Ansprüche, **dadurch gekennzeichnet, dass** der zumindest eine Kerbe-Eingriffsteil-Mechanismus unterschiedlich konfigurierte Kerben (10, 10') und unterschiedlich konfigurierte Eingriffsteile (20, 20') umfasst.

## Claims

1. Vacuum system with a device for movement transmission, torque transmission, force transmission and/or movement enablement, in particular for forming a gear and/or guidance mechanism, with:
- at least one notch-engagement part mechanism which is formed by at least one notch (10, 10') and at least one engagement part (20, 20'),
wherein,
- in addition, at least two contact surfaces (F1, F2) are formed and at least one
contact surface (F1) is configured to roll along the other contact surface (F2), **characterised in that**
- on one contact surface (F2), at least one side portion (SF) is provided for lateral guidance of at least one engagement part (20') and the lateral guidance takes place by means of at least one temporary discrete operative contact between the side portion (SF) and the at least one engagement part (20'),
and wherein
- a functional part (FT) which is movable by means of the at least two contact surfaces (F1, F2) and the at least one notch-engagement part mechanism so that it can be brought from a starting position into a target position and vice versa, wherein the functional part (FT) comprises a closure apparatus for opening and closing an opening (Ö) or a workpiece transfer apparatus for transferring workpieces, and
- a motor-drivable operative means (AM) which is configured to generate a pressure between the at least two contact surfaces (F1, F2) and to move the functional part (FT), and wherein
- the pressure is generated from outside through a chamber wall by means of a remotely-acting force, and the functional part (FT) is moved from outside through the chamber wall by means of a remotely-acting force, and wherein
- the device is arranged within a chamber, with the exception of the operative means (AM), which is arranged outside the chamber in order to act by means of a remotely-acting force through the chamber wall (KW) into the chamber.

2. Vacuum system with the device according to claim 1, **characterised in that**
- at least one notch-engagement part mechanism is provided laterally to the two contact surfaces (F1, F2), or
- at least two notch-engagement part mechanisms are provided, between which the two contact surfaces (F1, F2) are arranged.

3. Vacuum system with the device according to one of the preceding claims, **characterised in that** the at least one notch (10, 10') has a notch bottom (11, 11') and the at least one engagement part (20, 20') has a front end region (21, 21').

4. Vacuum system with the device according to claim 3, **characterised in that** a contact surface (F1) is configured almost flush with the at least one notch bottom (11') and the other contact surface (F2) is configured at least almost flush with at least one front end region (21).

5. Vacuum system with the device according to claim 3 or 4, **characterised in that**, during a rolling process, a contact surface (F1) adopts an at least almost flush alignment with at least one front end region (21), and the other contact surface (F2) adopts an at least almost flush alignment with at least one notch bottom (11').

6. Vacuum system with the device according to one of the claims 3 to 5, **characterised in that** at least one notch bottom (11') and at least one front end region (21) are configured for contacting operative connection with one another, wherein the at least one notch bottom (11') is formed on a movable part (T1) and the at least one front end region (21) is formed on a stationary part (T2).

7. Vacuum system with the device according to one of the claims 3 to 6, **characterised in that** at least one notch bottom (11) and at least one front end region (21') are configured so that they remain spaced from one another, even if the corresponding engagement part (20') is positioned to a maximum extent in a corresponding notch (10), wherein the notch bottom (11) is formed on a stationary part (T2) and the front end region (21') is formed on a movable part (T1).

8. Vacuum system with the device according to one of the preceding claims, **characterised in that** the notch-engagement part mechanism is configured so that a contacting operative connection of a notch bottom-engagement part pair (11', 21) is followed by a notch bottom-engagement part pair (11, 21'), the notch bottom (11) and front end region (21') of which remain spaced from one another even when the corresponding engagement part (20') is positioned to a maximum extent in the corresponding notch (10) or vice versa.

9. Vacuum system with the device according to one of the preceding claims, **characterised in that** provided on a contact surface (F2) is at least one side portion (SF) for lateral guidance of at least one engagement part (20') which is exposed by at least one notch (10).

10. Vacuum system with the device according to one of the preceding claims, **characterised in that** the at least one side portion (SF) and the at least one engagement part (20') for lateral guidance are inclined.

11. Vacuum system with the device according to one of the preceding claims, **characterised in that** the side portion (SF) is inclined at a different inclination angle than the at least one engagement part (20').

12. Vacuum system with the device according to one of the preceding claims, **characterised in that**
- one contact surface (F1) is configured, at least in parts, curved, specifically circular or circular arc-shaped and the other contact surface (F2) is configured, at least in parts, planar, or
- two contact surfaces (F1, F2) are configured curved, specifically circular or circular arc-shaped.

13. Vacuum system with a device according to one of the preceding claims, **characterised in that** the at least one notch-engagement mechanism comprises differently configured notches (10, 10') and differently configured engagement parts (20, 20').

## Revendications

1. Installation sous vide avec un dispositif pour la transmission de mouvement, la transmission de couple de rotation, la transmission de force et/ou la permission de mouvement, en particulier pour réaliser un mécanisme de transmission et/ou de guidage, avec :
- au moins un mécanisme à partie de prise et à encoche, qui est formé par au moins une encoche (10, 10') et au moins une partie de prise (20, 20'),
dans laquelle
- en supplément au moins deux surfaces de contact (F1, F2) sont réalisées et au moins une surface de contact (F1) peut rouler le long de l'autre surface de contact (F2),
**caractérisée en ce**
- **qu'**au moins une section latérale (SF) pour guider latéralement au moins une partie de prise (20') est prévue sur une surface de contact (F2) et le guidage latéral est effectué par au moins une mise en contact active discrète temporaire entre la section latérale (SF) et l'au moins une partie de prise (20'),
et dans laquelle
- une partie fonctionnelle (FT) est mobile au moyen des au moins deux surfaces de contact (F1, F2) et de l'au moins un mécanisme à partie prise et à encoche de telle sorte qu'elle peut être amenée depuis une position de départ dans une position cible, et inversement, dans laquelle la partie fonctionnelle (FT) comprend un système de fermeture pour ouvrir et fermer une ouverture (Ö) ou un système de transfert de pièces pour transférer des pièces, et
- un moyen actif (AM) pouvant être entraîné de manière motorisée est. réalisé pour générer une pression entre les au moins deux surfaces de contact (F1, F2) et pour déplacer la partie fonctionnelle (FT), et dans laquelle
- la pression est générée depuis l'extérieur à travers une paroi de chambre au moyen d'une force ayant une action à distance, et la partie fonctionnelle (FT) est déplacée depuis l'extérieur à travers la paroi de chambre au moyen d'une force ayant une action à distance, et dans laquelle
- le dispositif est disposé à l'intérieur d'une chambre, à l'exception du moyen actif (AM), qui est disposé à l'extérieur de la chambre, pour agir à l'intérieur de la chambre depuis l'extérieur au moyen d'une force ayant une action à distance à travers la paroi de chambre (KW).

2. Installation sous vide avec le dispositif selon la revendication 1, **caractérisée en ce**
- **qu'**au moins un mécanisme à partie de prise et à encoche est réalisé latéralement par rapport aux deux surfaces de contact (F1, F2), ou
- **qu'**au moins deux mécanismes à partie de prise et à encoche sont réalisés, entre lesquels les deux surfaces de contact (F1, F2) sont disposées.

3. Installation sous vide avec le dispositif selon l'une quelconque des revendications précédentes, **caractérisée en ce que** l'au moins une encoche (10, 10') présente un fond d'encoche (11, 11') et l'au moins une partie de prise (20, 20') présente une zone frontale (21, 21').

4. Installation sous vide avec le dispositif selon la revendication 3, **caractérisée en ce qu'**une surface de contact (F1) est réalisée au moins quasiment en affleurement par rapport à au moins un fond d'encoche (11') et l'autre surface de contact (F2) est réalisée au moins quasiment en affleurement par rapport à au moins une zone frontale (21).

5. Installation sous vide avec le dispositif selon la revendication 3 ou 4, **caractérisée en ce qu'**une surface de contact (F1) adopte pendant une opération de roulement une orientation au moins quasiment en affleurement par rapport à au moins une zone frontale (21), et l'autre surface de contact (F2) adopte pendant l'opération de roulement une orientation au moins quasiment en affleurement par rapport à au moins un fond d'encoche (11').

6. Installation sous vide avec le dispositif selon l'une quelconque des revendications 3 à 5, **caractérisée en ce qu'**au moins un fond d'encoche (11') et au moins une zone frontale (21) sont réalisés pour la liaison active l'un à l'autre de mise en contact, dans laquelle l'au moins un fond d'encoche (11') est réalisé sur une partie mobile (T1) et l'au moins une zone frontale (21) est réalisée sur une partie immobile (T2).

7. Installation sous vide avec le dispositif selon l'une quelconque des revendications 3 à 6, **caractérisée en ce qu'**au moins un fond d'encoche (11) et au moins une zone frontale (21') sont réalisés de telle sorte qu'ils restent à distance l'un de l'autre même quand la partie de prise (20') correspondante est positionnée au maximum dans une encoche (10) correspondante, dans laquelle le fond d'encoche (11) est réalisé sur une partie immobile (T2) et la zone frontale (21') est réalisée sur une partie mobile (T1).

8. Installation sous vide avec le dispositif selon l'une quelconque des revendications précédentes, **caractérisée en ce que** le mécanisme à partie de prise et à encoche est réalisé de telle sorte qu'une paire zone frontale-fond d'encoche (11, 21'), dont le fond d'encoche (11) et la zone frontale (21') restent à distance l'un de l'autre même quand la partie de prise (20') correspondante est positionnée au maximum dans l'encoche (10) correspondante, suit une liaison active de mise en contact d'une paire zone frontale- fond d'encoche (11', 21), ou inversement.

9. Installation sous vide avec le dispositif selon l'une quelconque des revendications précédentes, **caractérisée en ce qu'**au moins une section latérale (SF) pour guider latéralement au moins une partie de prise (20'), laquelle est dégagée par au moins une encoche (10), est prévue sur une surface de contact (F2).

10. Installation sous vide avec le dispositif selon l'une quelconque des revendications précédentes, **caractérisée en ce que** l'au moins une section latérale (SF) et l'au moins une partie de prise (20') sont chanfreinées pour le guidage latéral.

11. Installation sous vide avec le dispositif selon l'une quelconque des revendications précédentes, **caractérisée en ce que** la section latérale (SF) est chanfreinée avec un autre angle d'inclinaison que l'au moins une partie de prise (20').

12. Installation sous vide avec le dispositif selon l'une quelconque des revendications précédentes, **caractérisée en ce**
- **qu'**une surface de contact (F1) est réalisée de manière incurvée au moins par endroits, à savoir en forme de cercle ou d'arc de cercle, et l'autre surface de contact (F2) est réalisée au moins par endroits de manière plane, ou
- **que** deux surfaces de contact (F1, F2) sont réalisées de manière incurvée, à savoir en forme de cercle ou d'arc de cercle.

13. Installation sous vide avec un dispositif selon l'une quelconque des revendications précédentes, **caractérisée en ce que** l'au moins un mécanisme à partie de prise et à encoche comprend des encoches (10, 10') à configuration différente et des parties de prise (20, 20') à configuration différente.
